# EUROPEAN PATENT SPECIFICATION

(11) **EP 2 921 244 B1**
(45) Date of publication and mention of the grant of the patent: **04.05.2022**
(21) Application number: 15000675.7
(22) Date of filing: 06.03.2015
(51) Int. Cl.: C30B 11/00, C30B 29/52

(54) **Method of the directional solidification of the castings of gas turbine blades and a device for producing the castings of gas turbine blades of the directional solidified and monocrystalline structure**
VERFAHREN ZUR GERICHTETEN SOLIDIFIKATION DER GUSSTEILE VON GASTURBINENSCHAUFELN UND VORRICHTUNG ZUR HERSTELLUNG DER GUSSTEILE VON GASTURBINENSCHAUFELN MIT GERICHTETER SOLIDIFIZIERTER UND MONOKRISTALLINER STRUKTUR
PROCÉDÉ DE SOLIDIFICATION DIRECTIONNELLE DE PIÈCES MOULÉES D'AUBES DE TURBINE À GAZ ET DISPOSITIF POUR PRODUIRE DE TELLES PIÈCES MOULÉES D'UNE STRUCTURE MONOCRISTALLINE ET SOLIDIFIÉE DIRECTIONNELLE

(30) Priority: 13.03.2014 PL 40751814
(43) Date of publication of application: 23.09.2015
(73) Proprietor: Seco/Warwick S.A., 66-200 Swiebodzin (PL)
(72) Inventor: Wiechczynski, Artur, 66-200 Swiebodzin (PL); Lisiewicz, Marcin, 66-100 Brzezie k. Sulechowa (PL); Kwasnicka, Julia, 04119 Kijow (UA); Kostrica, Walentyn, 03115 Kijow (UA)
(74) Representative: Passowicz, Marek

(56) References cited:
- EP-A2- 1 321 208
- EP-A2- 2 727 669
- None

## Description

### Field of invention

The subject matter of this invention is a method of the directional solidification of the castings of gas turbine blades and a device for producing the castings of gas turbine blades of the directional solidified and monocrystalline structure.

The invention relates to the field of the foundry technology, in particular the treatment of the molten mass in the mold by cooling thereof, and may be applied in the production of heat-resistant alloy castings of the stator blades and rotor blades of the gas turbines.

### Background of invention

There are known methods of producing the castings of gas turbine blades, which have the directionally solidified and single crystal structure, based on the directional solidification of the heat resistant alloy melt in the casting mold, which were disclosed in the Russian patents: RU2152844 (B22D27/04, published on 20.07.2000); RU2157296 (B22D27/04, published on 10.10.2000); RU2211746 (B22D27/04, published on 26.12.2001) and also in the American patent publication No. US 6,311,760 B2 and in the European patent publications No.: EP 2 727 669 A2 an EP 1 321 208 A2.

The known methods comprise a vertical movement of a vacuum ceramic shell mold with a solidifying alloy from a heating zone into a cooling zone, and its cooling with the streams of an inert gas, wherein the inert gas streams are produced by ejectors with nozzles directing the cooling streams mainly radially to the axis and / or along the axis of the cooling zone from top to bottom.

The closest method in terms of the technical essence and the achieved technical result is a method of manufacturing a turbine blade casting of the directionally solidified and single crystal structure disclosed in American patent publication No.US 5,921,310 (B22D27/04; published on 13.07.1999), which includes the movement of the casting mold to be filled with a molten mass into a heating zone, pouring the melt of heat resistant alloy, which temperature is above the liquidus temperature of the alloy from the crucible, the movement of the vacuum casting mold with a molten mass from the heating zone into the cooling zone through the opening of the thermal insulating screen and the directional solidification of the heat resistant alloy melt by cooling the casting mold with the streams of the inert gas in the upper part of the cooling zone, at the distance no greater than 40 mm from the upper part of the cooling zone, which are directed through the openings or nozzles, downwardly and along the exterior surface of the casting mold.

A common disadvantage of the known methods is the difficulty in providing the stable and optimal cooling conditions during the casting of the blades with the chords of various widths in order to achieve the maximum longitudinal and the minimum transverse gradient of temperature on the solidification front. This leads to the structural defects in the casting, especially in the areas where casting goes from one thickness to the other, a reduction in the percentage of products that can be used and an excessive gas consumption.

Further a device for producing castings of gas turbine blades of the directional solidified and single crystal structure, made of heat resistant alloys, based on the directional solidification, is disclosed in patents: US 3,690,367 (B22D41/00, published on 12.09.1979), RU2152844 (B22D27/04, published on 20.07.2000), RU2157296 (B22D27/04, published on 10.10.2000), US 6,311,760 B2 (B22D27/04, published 06.11.2001) and RU2211746 (B22D27/04, published 26.12.2001). The most effective for the implementation of the directional solidification are devices for producing the castings, in the form of the vertical cylindrical chamber placed in a vacuum housing, divided with a thermal insulation screen with the central opening between a heating zone and a cooling zone. The chamber in the heating zone includes the apparatuses for melting and pouring alloy into the casting mold, and in the cooling zone - the nozzles for supplying a cooling agent, usually chilled inert gases, to the surface of the casting mold, which is guided from the heating zone into the cooling zone next to the nozzles.

A common disadvantage of the known devices is the difficulty in providing the stable and optimal conditions during the heating and the cooling of the casting mold with the molten mass, which are necessary to form the directional solidified and single crystal structure of the casting, over the entire height of the mold.

The closest device in terms of the technical essence and achieved technical result is a device for manufacturing a turbine blade casting of the directionally solidified and single crystal structure disclosed in American patent publication No. US 5,921,310 (B22D27/04; published on 13.07.1999), which consists of the cylindrical chamber placed in a vacuum housing, divided with a thermal insulating screen with the central opening between a heating zone and a cooling zone. Above the chamber an apparatus for melting and pouring alloy into the casting mold was placed, which has a rotary induction furnace, a crucible for melting and a pouring hopper. In addition, the described device comprises a drive for vertical movement of a water - cooled solidifier, on which the casting mold is placed.

The chamber of the device in the heating zone has an inductor, a thermal insulation layer and a graphite muffle, and in the cooling zone - a water-cooled housing and a device for supplying inert gas streams, in the form of a chamber with the nozzles, and additionally a part of the central opening in thermal insulation screen is closed by a annular seal, formed by flexible flakes made of the thermal insulation material.

In addition, the device for supplying the streams of cooling inert gas provides cooling of the casting mold in the area, where part of the molten mass is already solidified, at the distance no greater than 40 mm from the upper part of the cooling device, wherein the nozzles direct the stream of inert gas downwardly and along the exterior surface of the casting mold through the invariant trajectories.

The device described above performs a method for producing castings of gas turbine blades of the directional solidified and single crystal structure, which includes the movement of the casting mold to be filled with a molten mass into a heating zone, pouring from the crucible the melt of heat resistant alloy, which temperature is above the liquidus temperature of the alloy, the movement of the vacuum casting mold with a molten mass from the heating zone into the cooling zone through the opening in the thermal insulating screen and the directional solidification of the heat resistant alloy melt by cooling the casting mold with the streams of the inert gas in the upper part of the cooling zone at the distance no greater than 40 mm from the upper part of the cooling zone.

The similar device was also presented in the patent publication No. EP 2 727 669 A2.

The disadvantages of the both devices are non-optimal solutions in the structure of the chamber elements, that:
- limit the technological potential of the device due to the inability to achieve maximum cooling efficiency of the mold in the production of the blades of different configurations and different widths of the chord,
- do not provide sufficiently high longitudinal and sufficiently low transverse temperature gradients on the solidification front, that are necessary to avoid structural defects in the casting,
- reduce the quality of the casting and the percentage of products that can be used.

The purpose and the technical result of the invention is to provide a method of the directional solidification of the castings of gas turbine blades, providing optimal conditions for the development of the directional and single crystal structure of the metal, regardless of the width of blades chords, with no defects in the casting, in the areas where casting goes from one thickness to the other.

### Summary of invention

The nature of the method according to the present invention, comprising a vertical movement of a vacuum ceramic shell mold with a solidifying molten mass from a heating zone into a cooling zone, and its cooling with the stream of the inert gas, directed to the mold in the upper part of the cooling zone, **consists in the fact that** during the phase of the blade casting cooling, the stream of inert gas reaches supersonic velocity at the nozzle outlet, with a consumption of 0.5-2 g/s per nozzle, wherein the optimum number of inert gas streams is dependent on the chord of the blade casting, as follows:
a/ in case of the chord up to 50 mm - one supersonic stream is used, which is directed to the mold in the area of the solidification of the nearest edge of the blade casting;
b/ in case of chord from 50 mm to 70 mm - two supersonic streams are used, which are directed to the mold in the area of the solidification of the pressure face and in the area of the solidification of the suction face of the blade casting, respectively;
c/ in case of chord above 70 mm - three supersonic streams are used, which are directed to the mold in the area of the solidification of the nearest edge, in the area of the solidification of the pressure face and in the area of the solidification of the suction face of the blade casting, respectively.

In turn, the subject matter of the present invention is also a device which comprises: a vertical technological chamber placed in a vacuum housing in which, over said technological chamber, there is also placed a device for melting of alloy and pouring of molten mass into a casting mold, and also a drive forcing an axial moving "up-and-down" of a water-cooled plate crystallizer, on which said casting mold is located, and what's more said technological chamber is divided horizontally with a replaceable thermal insulating screen in the form of a shield with a central opening into the heating zone and a two-piece cooling zone in a housing said screen is placed on a retaining ring, mounted in a cylindrical wall, between the heating and a two-piece-cooling zones, at the distance from the base of the wall of 0,30-0,55, preferably of 0,25 of its height, wherein, in the housing of the cooling zone, there is placed an annular gas collector supplying the streams of the cooling inert gas, however its nature consists in the fact that said collector is equipped with appropriate number of the bidirectional gas ejectors with the supersonic nozzles, which are arranged at a distance of at least 40 mm, preferably 45-75 mm from the bottom surface of the thermal insulating screen, wherein the basic operational parameters of the supersonic nozzles of the annular gas collector are as follows: a critical diameter of 0.7-1.5 mm, a divergence angle of 10-15° and the gas consumption per nozzle 0.5-2 g/s at a gas pressure in the critical cross-section of the nozzle of 3-10 bar,
whereas an amount of the used gas ejectors with supersonic nozzles is depended to' the chord dimension of the cooled blade casting per following relations:
one gas ejector for the chord up to 50 mm,
two gas ejectors for the chord between 50 mm to 70 mm,
three gas ejectors for the chord above 70 mm.

It is favorable when the technological chamber in the heating zone comprises a heating inductor and a graphite muffle, separated by the thermal insulating layer, whereas in the inner wall of the annular gas collector, situated in the cooling zone, there are arranged openings for seating the gas ejectors with the supersonic nozzles.

It is also favorable when the part of the central opening in the replaceable thermal insulating screen is closed by flexible flakes made of thermal insulating material in the form of circular sectors, obtained by the radial incisions in said screen.

It further is favorable when the replaceable thermal insulating screen has a variable diameter of a central opening, corresponding to the diameter of the casting mold.

Moreover, it is further favorable s when the retaining ring of the thermal insulating screen is made of carbon composite, and the cylindrical wall of the thermal insulating screen is made of a pressed graphite felt.

Besides, it is favorable when the housing of the technological chamber in the cooling zone is equipped with water cooling.

### Brief description of drawing

The invention will be better described based on an embodiment of the device shown in the drawing, wherein the following figures show:

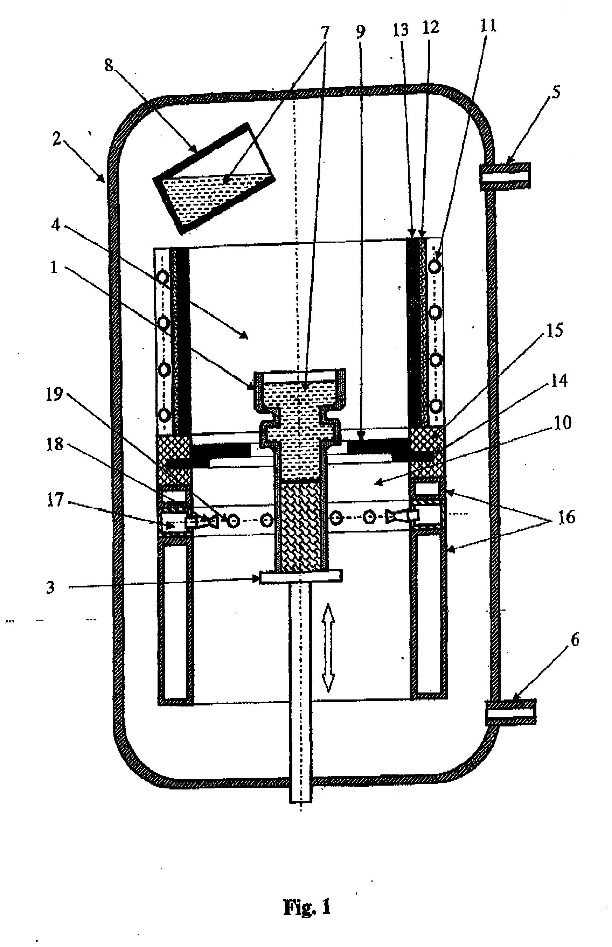

- Fig. 1 -: an axial longitudinal section of the device according to the invention,
- Fig. 2 -: the blade casting cooling scheme, using one supersonic stream of the inert gas, which is directed to the mold in the area of the solidification of the nearest edge of the blade casting,
- Fig. 3 -: the blade casting cooling scheme, using two supersonic streams of the inert gas, which are directed to the mold in the areas of the solidification of the pressure face and the suction face of the blade casting,
- Fig. 4 -: the blade casting cooling scheme, using three supersonic streams of the inert gas, which are directed to the mold in the areas of the solidification of the nearest edge, the pressure face and the suction face of the blade casting.

### Detailed description of preferred embodiment

The castings of gas turbine blades were produced with a prismatic lock (a tip) and profile chords of 45 mm, 62 mm and 74 mm. To produce them ceramic shell molds have been used of constant wall thickness of 12 ± 1 mm. The outer surface of the mold was smooth, without sprinkles.

A casting mold (1) in the form of a ceramic shell is situated in a vacuum housing (2) of a casting device with a vertical technological chamber. The mold (1) is placed on a water-cooled plate crystallizer (3), and by means of the drive system it can be moved to the chamber's heating zone (4) of underneath the device for melting the alloy and pouring the melt into the casting mold (1). The housing (2) is connected to a vacuum installation through the stub pipes (5) and (6). After melting the heat resistant alloy in the device for melting and casting at a temperature above the liquidus temperature, it is poured from a crucible (8) into the casting mold (1), and then moved through a thermal insulating screen (9) with a central opening to a cooling zone (10) of the technological chamber.

In order to provide the required temperature of the molten mass in the casting mold (1), the technological chamber, in its heating zone (4), includes a heating inductor (11) with thermal insulation (12), and a graphite muffle (13), which are concentrically established.

The reduction of the heat transfer between the zones (4) and (10) is achieved by interposing the thermal insulating screen (9), wherein said screen (9) is disposed on a thin retaining ring (14), which is pressed into a cylindrical wall (15), made of the heat insulating material, for example of pressed graphite felt. The thin retaining ring (14) is made of a heat resistant material, for example carbon composite. The screen (9) may also be partially pressed into the cylindrical wall (15). The fact that the thermal insulating screen (9) is designed as a removable allows to easily and quickly replace it, when the production of another type of casting blades is planned. The screen (9) can be installed on the retaining ring (14) either manually or in an automated way without the aeration of the vacuum housing.

Reliability of the thermal insulation between the heating zone (4) and the cooling zone (10) is provided by: minimum allowed distance between them, placing the retaining ring (14) at a distance from the base of the cylindrical wall (15) of 0,30-0,55 of its height, and the partial closure of the opening in the thermal insulating screen (9) with the flexible thermal insulating flakes in the form of circular sectors. With the movement of the casting mold (1), the flexible flakes flex and take a position at which the area of the central opening of the thermal insulating screen (9) is minimal.

In order to expand the technological possibilities of the device and to ensure optimal conditions for the directional solidification of the molten mass, a technological chamber's housing (16), in the cooling zone (10), is equipped with the water cooling system and is made of two parts, between which a device for introducing the cooling inert gas streams is placed. The device for introducing the cooling gas streams is made in the form of an annular gas collector (17), equipped with the gas ejectors (18), which are placed in a row at a distance of 45-75 mm from the bottom surface of the thermal insulating screen (9), and have the ability to change the direction of the flow of the cooling gas.

In order to ensure the various variants of the arrangement of the ejectors (18), the openings (19) for the ejectors are made in the inner wall of the annular collector (17), which can be closed by sealing plugs.

An important characteristic of the ejectors (18) is the ability to change the direction of the flow of the cooling inert gas, that is applied to the moving casting mold (1) with a supersonic gas flow rate. For this purpose the known gas ejectors with supersonic nozzles can be used. The optimal operating parameter of the ejector (18) with the supersonic nozzle of the critical diameter of 0.7-1.5 mm and an obtuse angle of 10-15° is gas consumption per nozzle of 0.5-2 g/s at a gas pressure in the critical section of the nozzle of 3-10 bar. The changes in the cooling gas flow direction are achieved by mounting the ejectors in the corresponding openings (19) and/or by rotating the ejectors, for example, using ball joints and/or by rotating the diffuser.

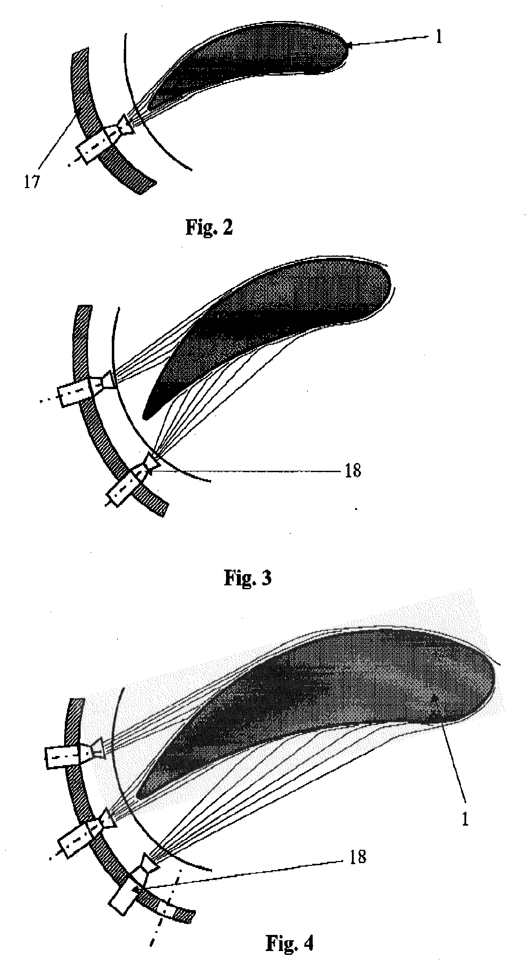

The ability to change the direction of flow of the cooling gas helps to accomplish the optimal modes of solidification of the molten mass in the production of blades with different configurations and different widths of the chord. By changing the flow vertically (mainly downwards) and horizontally, minimum temperature longitudinal gradients are achieved. At the same time for cooling of the blade casting with the chord 45mm it is sufficient to use one ejector with the supersonic stream of the inert gas with a consumption per nozzle of 0.5-2 g/s, which is directed to the casting mold (1) in the area of the solidification of the nearest (e.g. trailing) edge of the blade casting (fig. 2).

For cooling of the blade casting with the chord of 62 mm it is sufficient to use two ejectors with supersonic streams of the cooling inert gas with a consumption per nozzle of 0.5-2 g/s, which are directed to the mold in the areas of the solidification of the pressure face and the suction face of the blade casting (fig.3).

For cooling of the blade casting with the chord of 74mm it is sufficient to use three ejectors with supersonic streams of the inert gas with a consumption per nozzle of 0.5-2 g/s, which are directed to the mold in the areas of the solidification of the nearest edge, the pressure face and the suction face of the blade casting (fig.4).

The device according to the present invention helps to achieve the assumed technical result: increased technological capabilities and optimal conditions for the directional solidification of the molten mass in the production of blades of different configurations and different widths of the chord, with a high percentage of products suitable for use.

The shell molds are made of electro-corundum ceramics based on a standard method of melted models. After pouring the molten mass type CMSX - 4 into molds, they were moved vertically from the heating zone to the cooling zone at a rate of 4-8 mm/min. In the cooling zone, especially at a distance of 60mm from the upper border of the cooling zone, the mold in the area of solidification of the blade was cooled with a stream of inert gas - argon - from the fixed, known ejectors with supersonic nozzles, that provide a supersonic stream of the inert gas at the outlet. The residual pressure of the inert gas in a vacuum cooling zone was 230 mbar.

The variants of the method according to the invention can be implemented irrespective of the arrangement of the mold on the solidifier, but during the casting of the block of several blades the most desirable arrangement of the blade chord is along the radius of the solidifier and the arrangement of one edge of the blade near the edge of the solidifier. The said edge of the blade is placed the closest to the source of the stream (s) of the cooling gas.

The result of the implementation of all embodiments of the method according to the invention was the obtainment the castings of gas turbine blades of different sizes with a single crystal structure of the metal, in which there was no structural defects associated with the shrinkage, especially in the areas between the blade and the tip of the blade.

### List of references

1 - casting mold;
2 - vacuum housing of casting device with the vertical technological chamber;
3 - water-cooled plate crystallizer;
4 - heating zone of the technological chamber;
5 - stub pipe for attaching the vacuum installation;
6 - stub pipe for attaching the vacuum installation;
7 - molten mass;
8 - crucible of the filling device with the molten mass;
9 - thermal insulating screen with the central opening;
10 - cooling zone of the technological chamber;
11 - heating inductor;
12 - thermal insulation layer of the heating inductor;
13 - graphite muffle;
14 - retaining ring of the thermal insulating screen;
15 - cylindrical wall of the thermal insulating screen;
16 - technological chamber's housing in the cooling zone;
17 - annular gas collector;
18 - gas ejectors equipped with the supersonic nuzzles;
19 - openings for the gas ejectors.

## Claims

1. A method of carrying out a directional solidification of castings in a process of the gas turbine blades manufacturing, comprising a vertical movement of a vacuum ceramic shell mold with a solidifying molten mass from a heating zone into a cooling zone, and its cooling with at least one stream of inert gas, directed to the mold in the upper part of the cooling zone, **wherein** during the phase of the blade casting cooling, the stream of inert gas reaches supersonic velocity at the nozzle outlet, with a gas consumption of 0.5-2 g/s per nozzle, wherein the optimum number of inert gas streams is dependent on the chord dimension of the blade casting per following relations:
a/ in case of the chord up to 50 mm - one supersonic stream is used, which is directed to the mold in the area of the solidification of the nearest edge of the blade casting;
b/ in case of chord from 50 mm to 70 mm - two supersonic streams are used, which are directed to the mold in the area of the solidification of the pressure face and in the area of the solidification of the suction face of the blade casting, respectively;
c/ in case of chord above 70 mm - three supersonic streams are used, which are directed to the mold in the area of the solidification of the nearest edge, in the area of the solidification of the pressure face and in the area of the solidification of the suction face of the blade casting, respectively.

2. A device for producing the castings of gas turbine blades of the directional solidified and monocrystalline structure, comprising a vertical technological chamber placed in a vacuum housing (2) in which, over said technological chamber, there is also placed a device for melting of alloy and pouring of molten mass (7) into a casting mold (1), and also a drive forcing an axial moving "up-and-down" of a water-cooled plate crystallizer (3), on which said casting mold (1) is located, and what's more said technological chamber is divided horizontally with a replaceable thermal insulating screen (9) in the form of a shield with a central opening into the heating zone (4) and a two-piece cooling zone (10) in a housing (16), wherein said screen (9) is placed on a retaining ring (14), mounted in a cylindrical wall (15), between the heating and cooling zones (4 and 10), at the distance from the base of the wall of 0,30-0,55, preferably of 0,25 of its height, wherein, in the housing (16) of the cooling zone (10), there is placed an annular gas collector (17) supplying the streams of the cooling inert gas, **characterized in that** said collector (17) is equipped with appropriate number of the bidirectional gas ejectors (18) equipped with the supersonic nozzles, which are arranged at a distance of at least 40 mm, preferably 45-75 mm from the bottom surface of the thermal insulating screen (9), wherein the basic operational parameters of the supersonic nozzles of the annular gas collector (17) are as follows: a critical diameter of 0.7-1.5 mm, a divergence angle of 10-15° and the gas consumption per nozzle 0.5-2 g/s at a gas pressure in the critical cross-section of the nozzle of 3-10 bar,
whereas an amount of the used gas ejectors (18) equipped with supersonic nozzles is depended to the chord dimension of the cooled blade casting per following relations:
one gas ejector (18) for the chord up to 50 mm,
two gas ejectors (18) for the chord between 50 mm to 70 mm,
three gas ejectors (18) for the chord above 70 mm.

3. The device according to claim 2, **characterized in that** the technological chamber in the heating zone (4) comprises a heating inductor (11) and a graphite muffle (13), separated by the thermal insulating layer (12), whereas, in the cooling zone (10), there are arranged openings (19) in a inner wall of the annular gas collector (17) for seating the gas ejectors (18) with the supersonic nozzles.

4. The device according to claim 2 or 3, **characterized in that** the part of the central opening in the replaceable thermal insulating screen (9) is closed by flexible flakes made of thermal insulating material in the form of circular sectors, obtained by the radial incisions in said screen (9).

5. The device according to one of the claims from 2 to 4, **characterized in that** the replaceable thermal insulating screen (9) has a variable diameter of a central opening, corresponding to the diameter of the casting mold (1).

6. The device according to one of the claims from 2 to 5, **characterized in that** the retaining ring (14) of the thermal insulating screen (9) is made of carbon composite, and the cylindrical wall (15) of the thermal insulating screen (9) is made of a pressed graphite felt.

7. The device according to one of the claims from 2 to 6, **characterized in that** the housing (16) of the technological chamber in the cooling zone (10) is equipped with a water cooling.

## Patentansprüche

1. Verfahren zur gerichteten Solidifikation in einem Produktionsprozess von Gasturbinenschaufeln, umfassend eine vertikale Bewegung einer Vakuum-Keramikschalenform mit einer erstarrenden Schmelzmasse von einer Heizzone in eine Kühlzone und deren Kühlung mit mindestens einem Inertgasstrom, der im oberen Teil der Kühlzone auf die Form gerichtet ist, wobei der Inertgasstrom während der Phase der Schaufelgusskühlung am Düsenauslass Überschallgeschwindigkeit erreicht, mit einem Gasverbrauch von 0.5-2 g/s pro Düse, wobei die optimale Anzahl der Inertgasströme von der Sehnenabmessung des Schaufelgussteils gemäß den folgenden Beziehungen abhängig ist:
a/ bei einer Sehne bis 50 mm wird ein Überschallstrom verwendet, der auf die Form im Bereich der Erstarrung der nächstgelegenen Kante des Schaufelgussteils gerichtet ist;
b/ bei einer Sehne von 50 mm bis 70 mm werden zwei Überschallströme verwendet, die auf die Form im Bereich der Erstarrung der Druckseite bzw. im Bereich der Erstarrung der Saugseite des Schaufelgussteils gerichtet sind;
c/ bei einer Sehne von mehr als 70 mm werden drei Überschallströme verwendet, die jeweils im Bereich der Erstarrung der nächstgelegenen Kante, im Bereich der Erstarrung der Druckseite und im Bereich der Erstarrung der Saugseite des Schaufelgussteils auf die Form gerichtet sind.

2. Vorrichtung zur Herstellung der Gussteile von Gasturbinenschaufeln mit gerichteter solidifizierter und monokristalliner Struktur, bestehend aus einer vertikalen technologischen Kammer, die in einem Vakuumgehäuse (2) angeordnet ist, in dem über der oben erwähnten technologischen Kammer auch eine Vorrichtung zum Schmelzen der Legierung und zum Gießen der geschmolzenen Masse (7) in eine Gießform (1) angeordnet ist, sowie ein Antrieb, der eine axiale Auf- und Abbewegung eines wassergekühlten Plattenkristallisators (3) erzwingt, auf dem sich die oben erwähnte Gießform (1) befindet, und außerdem die oben erwähnte technologische Kammer horizontal mit einem austauschbaren thermisch isolierenden Schirm (9) in Form eines Schildes mit einer zentralen Öffnung in die Heizzone (4) und eine zweiteilige Kühlzone (10) in einem Gehäuse (16) geteilt ist, wobei der Schirm (9) auf einem Haltering (14) angeordnet ist, der in einer zylindrischen Wand (15) zwischen der Heiz- und der Kühlzone (4 und 10) in einem Abstand von 0,30 bis 0,55, vorzugsweise 0,25 der Wandhöhe, von ihrer Basis angebracht ist, wobei im Gehäuse (16) der Kühlzone (10) ein ringförmiger Gassammler (17) angeordnet ist, der die Ströme des kühlenden Inertgases liefert, **dadurch gekennzeichnet, dass** der oben erwähnte Gassammler (17) mit einer angemessenen Anzahl von bidirektionalen Gasausstoßern (18) ausgestattet ist, die mit Übetschalldüsen versehen sind, die in einem Abstand von mindestens 40 mm, vorzugsweise 45-75 mm, von der Bodenfläche des thermisch isolierenden Schirms (9) angeordnet sind, wobei die grundlegenden Betriebsparameter der Überschalldüsen des ringförmigen Gassammlers (17) wie folgt sind: ein kritischer Durchmesser von 0,7-1,5 mm, ein Divergenzwinkel von 10-15° und der Gasverbrauch pro Düse 0,5-2 g/s bei einem Gasdruck im kritischen Querschnitt der Düse von 3-10 bar,
wobei die Anzahl der verwendeten, mit Überschalldüsen ausgestatteten Gasausstoßer (18) von der Sehnenabmessung des gekühlten Schaufelgussteils nach folgenden Beziehungen abhängig ist:
ein Gasausstoßer (18) für die Sehne bis 50 mm,
zwei Gasausstoßer (18) für die Sehne zwischen 50 mm und 70 mm,
drei Gasausstoßer (18) für die Sehne über 70 mm.

3. Vorrichtung nach Anspruch 2, **dadurch gekennzeichnet, dass** die technologische Kammer in der Heizzone (4) einen Heizinduktor (11) und eine Graphitmuffel (13) umfasst, die durch die thermisch isolierende Schicht (12) getrennt sind, während in der Kühlzone (10) in einer Innenwand des ringförmigen Gassammlers (17) Öffnungen (19) zur Aufnahme der Gasausstoßer (18) mit den Überschalldüsen angeordnet sind.

4. Vorrichtung nach Anspruch 2 oder 3, **dadurch gekennzeichnet, dass** der Teil der zentralen Öffnung in dem austauschbaren thermisch isolierenden Schirm (9) durch flexible Flocken aus wärmeisolierendem Material in Form von Kreissektoren verschlossen ist, die durch die radialen Einschnitte in dem oben erwähnten Schirm (9) erhalten werden.

5. Vorrichtung nach einem der Ansprüche 2 bis 4, **dadurch gekennzeichnet, dass** der austauschbare thermisch isolierende Schirm (9) einen variablen Durchmesser seiner zentralen Öffnung aufweist, der dem Durchmesser der Gießform (1) entspricht.

6. Vorrichtung nach einem der Ansprüche 2 bis 5, **dadurch gekennzeichnet, dass** der Haltering (14) des thermisch isolierenden Schirms (9) aus Kohlenstoffverbundwerkstoff und die zylindrische Wand (15) des thermisch isolierenden Schirms (9) aus einem gepressten Graphitfilz besteht.

7. Vorrichtung nach einem der Ansprüche 2 bis 6, **dadurch gekennzeichnet, dass** das Gehäuse (16) der technologischen Kammer in der Kühlzone (10) mit einer Wasserkühlung ausgestattet ist.

## Revendications

1. Procédé de solidification directionnelle de pièces coulées dans un processus de fabrication d'aubes de turbine à gaz, comprenant un mouvement vertical d'un moule en coquille en céramique sous vide avec une masse fondue en cours de solidification d'une zone de chauffage à une zone de refroidissement, et son refroidissement avec un courant de gaz inerte au moins, dirigé vers le moule dans la partie supérieure de la zone de refroidissement, **dans lequel**, pendant la phase de refroidissement de la pièce coulée d'aube, le courant de gaz inerte atteint une vitesse supersonique à la sortie de la buse, avec une consommation de gaz de 0,5 à 2 g/s par buse, tandis que le nombre optimal de courants de gaz inerte dépend de la dimension de la corde de la pièce coulée d'aube selon les relations suivantes :
a/ dans le cas d'une corde allant jusqu'à 50 mm - un courant supersonique est utilisé, qui est dirigé vers le moule dans la zone de solidification du bord le plus proche de la pièce coulée d'aube ;
b/ dans le cas d'une corde de 50 mm à 70 mm - deux courants supersoniques sont utilisés, qui sont dirigés vers le moule dans la zone de solidification de la face de pression et dans la zone de solidification de la face d'aspiration de la pièce coulée d'aube, respectivement ;
c/ dans le cas d'une corde supérieure à 70 mm - trois courants supersoniques sont utilisés, qui sont dirigés vers le moule dans la zone de solidification du bord le plus proche, dans la zone de solidification de la face de pression et dans la zone de solidification de la face d'aspiration de la pièce coulée d'aube, respectivement.

2. Dispositif pour la produire de pièces moulées d'aubes de turbine à gaz d'une structure monocristalline et à solidifiée directionnelle, comprenant une chambre technologique verticale placée dans une enceinte à vide (2) dans laquelle, au-dessus de ladite chambre technologique, il y a également un dispositif pour la fusion de l'alliage et le versement de la masse fondue (7) dans un moule de coulée (1), ainsi qu'un entraînement forçant un déplacement axial "vers le haut et vers le bas" d'un cristallisoir à plaques (3) refroidi par eau, sur lequel se trouve ledit moule de coulée (1), et qui plus est, ladite chambre technologique est divisée horizontalement avec un écran d'isolation thermique remplaçable (9) sous la forme d'un bouclier avec une ouverture centrale dans la zone de chauffage (4) et une zone de refroidissement en deux parties (10) dans un boîtier (16), dans lequel ledit écran (9) est placé sur une bague de retenue (14), monté dans une paroi cylindrique (15), entre les zones de chauffage et de refroidissement (4 et 10), à la distance de la base de la paroi de 0,30-0,55, de préférence de 0,25 de sa hauteur, dans lequel, dans le logement (16) de la zone de refroidissement (10), il est placé un collecteur de gaz annulaire (17) fournissant les courants du gaz inerte de refroidissement, **caractérisé en ce que** ledit collecteur (17) est équipé d'un nombre approprié d'éjecteurs de gaz bidirectionnels (18) équipés de buses supersoniques, qui sont disposés à une distance de 40 mm au moins, de préférence 45-75 mm, de la surface inférieure de l'écran d'isolation thermique (9), où les paramètres opérationnels de base des buses supersoniques du collecteur de gaz annulaire (17) sont les suivants : un diamètre critique de 0,7-1,5 mm, un angle de divergence de 10-15° et une consommation de gaz par buse de 0,5-2 g/s à une pression de gaz dans la section critique de la buse de 3-10 bar,
tandis que la quantité d'éjecteurs de gaz utilisés (18) équipés de buses supersoniques dépend de la dimension de la corde de la pièce de coulée d'aube refroidie selon les relations suivantes :
un éjecteur de gaz (18) pour la corde jusqu'à 50 mm,
deux éjecteurs de gaz (18) pour la corde entre 50 mm et 70 mm,
trois éjecteurs de gaz (18) pour la corde supérieure à 70 mm.

3. Dispositif selon la revendication 2, **caractérisé en ce que** la chambre technologique dans la zone de chauffage (4) comprend un inducteur de chauffage (11) et un moufle en graphite (13), séparés par la couche d'isolation thermique (12), tandis que, dans la zone de refroidissement (10), il y a des ouvertures (19) arrangées dans la paroi intérieure du collecteur de gaz annulaire (17) pour loger les éjecteurs de gaz (18) avec les buses supersoniques.

4. Dispositif selon la revendication 2 ou 3, **caractérisé en ce que** la partie de l'ouverture centrale dans l'écran d'isolation thermique remplaçable (9) est fermée par des flocons flexibles en matériau d'isolation thermique sous la forme de secteurs circulaires, obtenus par les incisions radiales dans ledit écran (9).

5. Dispositif selon l'une des revendications de 2 à 4, **caractérisé en ce que** l'écran thermoisolant remplaçable (9) présente un diamètre variable d'une ouverture centrale, correspondant au diamètre du moule de coulée (1).

6. Dispositif selon l'une des revendications 2 à 5, **caractérisé en ce que** la bague de retenue (14) de l'écran d'isolation thermique (9) est réalisée en composite de carbone, et la paroi cylindrique (15) de l'écran d'isolation thermique (9) est réalisée en feutre de graphite pressé.

7. Dispositif selon l'une des revendications de 2 à 6, **caractérisé en ce que** le logement (16) de la chambre technologique dans la zone de refroidissement (10) est équipé d'un refroidissement par eau.
